(19)

Europäisches
Patentamt
European
Patent Office
Office européen
des brevets

(11) **EP 4 266 076 A1**

(12) **EUROPEAN PATENT APPLICATION**

(43) Date of publication:
**25.10.2023 Bulletin 2023/43**

(51) International Patent Classification (IPC):
***G01R 33/561*** (2006.01)     ***G01R 33/44*** (2006.01)
***G01R 33/50*** (2006.01)     ***G01R 33/56*** (2006.01)

(21) Application number: **22169337.7**

(22) Date of filing: **21.04.2022**

(52) Cooperative Patent Classification (CPC):
**G01R 33/5602**; G01R 33/5607; G01R 33/5613

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Academisch Medisch Centrum
1105 AZ Amsterdam (NL)**

(72) Inventors:
• **Gurney-Champion, Oliver
1382VV Weesp (NL)**
• **Wennen, Myrte
3813LN Amersfoort (NL)**

(74) Representative: **Mewburn Ellis LLP
Aurora Building
Counterslip
Bristol BS1 6BX (GB)**

(54) **METHOD OF ESTIMATING RELAXATION TIME FROM GRADIENT ECHO MAGNETIC RESONANCE IMAGES**

(57)    The present disclosure relates to method and computing system (401) for estimating relaxation time (T1) from gradient echo magnetic resonance images. The method comprises generating an equation representing relationship between the relaxation time (T1) and Magnetic Resonance Imaging (MRI) signal (S) acquired at an instance after application of Radio Frequency (RF) pulse from plurality of RF pulses (k) applied after temporal gap and prior to acquisition of the MRI signal (S). The equation is generated based on relaxation factor $E_1$ representing T1 relaxation during repetition time (TR), additional relaxation factor ($E_{1,gap}$) representing additional T1 relaxation during repetition time of temporal gap ($TR_{gap}$), and flip angle ($\alpha$). The temporal gap is used for applying preparation pulses after the plurality of RF pulses (k) having a pre-defined gap between each other. Further, the method comprises estimating the relaxation time (T1) from the gradient echo magnetic resonance images, based on the equation.

FIGURE 3

EP 4 266 076 A1

**Description**

**TECHNICAL FIELD**

The present disclosure generally relates to the field of Magnetic Resonance Imaging (MRI). More particularly, the present disclosure relates to a method and a computing system for estimating relaxation time (T1) from gradient echo magnetic resonance images.

**BACKGROUND**

Magnetic Resonance Imaging (MRI) is a widely used technology because it achieves good spatial resolution and has excellent soft-tissue contrast. In conventional practice, diagnosis based on the MRI relies on qualitative assessment of images, which in turn relies on differences in contrast between and within tissues. However, the conventional practice lacks quantitative assessment of underlying tissue characteristics. The quantitative assessment helps to improve accuracy in the diagnosis and can therefore be used in a wide range of applications. These applications include, for example, detection of myocardial fibrosis and edema using tissue characteristics such as T1 and T2 relaxation times, predicting treatment response in tumors by modeling contrast inflow and outflow in tissues and determining underlying pharmacokinetic parameters, and the like.

For MRI, image quality is essential for discriminating structures and morphology for decision-making in the diagnosis. One of the factors hindering the implementation of the quantitative assessment may be decreased image quality. Techniques such as fat suppression and saturation slabs are crucial to improve the image quality of the MRI. Signals acquired from fat tissues are very bright and can thus cause bright artefacts in the MRI images acquired. Further, hydrogen atoms in the fat tissues are off-resonance, which causes the signals to shift in the image. Hence, the fat suppression plays an important role to eliminate the signals from the fat tissues by application of fat suppression pulses and improve the image quality. Further, other techniques such as, saturation pulses are applied to eliminate signals from unwanted tissues (e.g., to reduce motion artefacts) in Dynamic contrast-enhanced (DCE) MRI or Variable Flip Angle (VFA) T1 estimation using gradient echo sequences. However, application of such pulses disrupt the steady state magnetization that is the basis for estimating the tissue characteristics such as a relaxation time (T1) in VFA acquisitions and contrast agent concentration in DCE. This results in inaccurate estimates of T1 and the pharmacokinetic parameters in DCE. Therefore, most current guidelines *("Committee, D.M.T., DCE MRI Quantification Profile (1.0), Quantitative Imaging Biomarkers Alliance. 2012")* for the VFA T1 MRI and DCE MRI advise not to use such pulses. However, the lack of such pulses results in poor image quality of the images acquired by MRI.

The information disclosed in this background of the disclosure section is only for enhancement of understanding of the general background of the invention and should not be taken as an acknowledgement or any form of suggestion that this information forms the prior art already known to a person skilled in the art.

**SUMMARY**

In an embodiment, the present disclosure discloses a method of estimating a relaxation time (T1) from gradient echo magnetic resonance images. The method comprises generating an equation representing a relationship between the relaxation time (T1) and a Magnetic Resonance Imaging (MRI) signal ($S$) acquired at an instance after the application of a Radio Frequency (RF) pulse from a plurality of RF pulses (k) applied after a temporal gap and prior to the acquisition of the MRI signal ($S$). The equation is generated based on a relaxation factor $E_1$ representing T1 relaxation between two consecutive RF pulses during a repetition time (TR), an additional relaxation factor ($E_{1,gap}$) representing additional T1 relaxation during a repetition time of the temporal gap ($TR_{gap}$), a flip angle ($\alpha$) of the plurality of RF pulses *(k),* and *'n'* which indicates the number of the RF pulse after which the MRI signal is measured. The temporal gap can be used for applying preparation pulses, such as fat suppression, after the plurality of RF pulses (k) having a pre-defined gap between each other. Further, the method comprises estimating the relaxation time (T1) from one or more gradient echo magnetic resonance images, based on the equation.

In an embodiment, the present disclosure discloses a computing system for estimating a relaxation time (T1) from gradient echo magnetic resonance images. The computing system comprises a processor and a memory. The processor is configured to generate an equation representing a relationship between the relaxation time (T1) and a Magnetic Resonance Imaging (MRI) signal ($S$) acquired at an instance after application of a Radio Frequency (RF) pulse from a plurality of RF pulses ($k$) applied after a temporal gap and prior to acquisition of the MRI signal ($S$). The equation is generated based on a relaxation factor $E_1$ representing T1 relaxation between two consecutive RF pulses during a repetition time (TR), an additional relaxation factor ($E_{1,gap}$) representing additional T1 relaxation during a repetition time of the temporal gap ($TR_{gap}$), a flip angle ($\alpha$) of the plurality of RF pulses *(k),* and *'n'* which indicates the number of the RF pulse after which the MRI signal is measured. The temporal gap can be used for applying preparation pulses, such as fat suppression, after the plurality of RF pulses (k) having a pre-defined gap between each other. Further, the processor is configured to estimate the relaxation time (T1) from one or more gradient echo magnetic resonance images, based on the equation.

As used in this summary, in the description below, in the claims below, and in the accompanying drawings, the term "relaxation time" is a time constant which determines the rate at which excited protons return to equilibrium in the MRI. It is a measure of time taken for spinning protons to realign with external magnetic field.

As used in this summary, in the description below, in the claims below, and in the accompanying drawings, the term "gradient echo magnetic resonance images" refers to images acquired by applying equally length gradient echo sequences with a pre-defined gap between each other and in which gradient fields are utilized to manipulate the transverse magnetisation.

As used in this summary, in the description below, in the claims below, and in the accompanying drawings, the term "temporal gap" may refer to a gap that is used to apply preparation pulses after the plurality of RF pulses (k).

The foregoing summary is illustrative only and is not intended to be in any way limiting. In addition to the illustrative aspects, embodiments, and features described above, further aspects, embodiments, and features will become apparent by reference to the drawings and the following detailed description.

## BRIEF DESCRIPTION OF THE ACCOMPANYING DRAWINGS

The novel features and characteristics of the disclosure are set forth in the appended claims. The disclosure itself, however, as well as a preferred mode of use, further objectives, and advantages thereof, will best be understood by reference to the following detailed description of an illustrative embodiment when read in conjunction with the accompanying figures. One or more embodiments are now described, by way of example only, with reference to the accompanying figures wherein like reference numerals represent like elements and in which:

**Figure 1** illustrates a conventional gradient echo sequence;

**Figure 2** shows an exemplary flow chart illustrating method steps for estimating relaxation time from gradient echo magnetic resonance images, in accordance with some embodiments of the present disclosure;

**Figure 3** shows an exemplary method for estimating the relaxation time from the gradient echo magnetic resonance images, in accordance with some embodiments of the present disclosure; and

**Figure 4** shows a detailed diagram of a computing system for estimating the relaxation time from the gradient echo magnetic resonance images, in accordance with some embodiments of the present disclosure;

**Figures 5A-5D** show exemplary graphs for estimating the relaxation time from the gradient echo magnetic resonance images, in accordance with some embodiments of the present disclosure; and

**Figure 6** shows a block diagram of a general-purpose computing system for estimating the relaxation time from the gradient echo magnetic resonance images, in accordance with embodiments of the present disclosure.

It should be appreciated by those skilled in the art that any block diagram herein represents conceptual views of illustrative systems embodying the principles of the present subject matter. Similarly, it will be appreciated that any flow charts, flow diagrams, state transition diagrams, pseudo code, and the like represent various processes that may be substantially represented in computer readable medium and executed by a computer or processor, whether or not such computer or processor is explicitly shown.

## DETAILED DESCRIPTION

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below. It should be understood, however that it is not intended to limit the disclosure to the particular forms disclosed, but on the contrary, the disclosure is to cover all modifications, equivalents, and alternatives falling within the scope of the disclosure.

The terms "comprises", "comprising", or any other variations thereof, are intended to cover a non-exclusive inclusion, such that a setup, device or method that comprises a list of components or steps does not include only those components or steps but may include other components or steps not expressly listed or inherent to such setup or device or method. In other words, one or more elements in a system or apparatus proceeded by "comprises... a" does not, without more constraints, preclude the existence of other elements or additional elements in the system or apparatus.

Image quality plays an important role in Magnetic Resonance Imaging (MRI). Preparation pulses, such as fat suppression pulses, saturation pulses, and the like, are crucial for improving the MRI image quality. However, the application of the preparation pulses results in inaccurate estimates of relaxation time (T1). The present disclosure provides methods and systems to estimate the relaxation time (T1) including the effect of interruption of the steady state due to the preparation pulses. This increases the accuracy in estimation of the relaxation time (T1) while maintaining image quality in MRI.

MRI signal originates from RF waves induced by atomic nuclei in a body of a subject. Typically, spins originate from hydrogen atoms in the body, but other spins are also investigated. An external magnetic field is employed to align proton spins in the body that are normally randomly oriented. In the presence of an external magnetic field, an equilibrium is found in a situation where more spins align with the external magnetic field than counter aligned. The aligned spins are excited by the application of Radio Frequency (RF) pulses. The atomic nuclei with excited spins emits a radiofrequency wave, which in turn, are measured with a radiofrequency coil (receiver coil). Then, the atomic nuclei return back to equilibrium through T1 relaxation. Typically, the MRI signal is located by applying various gradients to magnetic field using gradient coils. In gradient echo MRI, an image is created by applying a series of RF pulses and gradients and measuring the MRI signal. By varying the pattern in which the RF pulses and gradients are applied, different types of images are created. Particularly, by maintaining short time between the RF pulses, T1 relaxation of the tissue is reduced, resulting in different tissue intensities based on T1 relaxation properties. The T1 relaxation time is a time constant which determines the rate at which excited protons return to the equilibrium. Particularly, it is a measure of time taken for spinning protons to realign with the external magnetic field, known as spin-lattice relaxation. Typically, a gradient echo sequence consists of a series of regularly spaced RF pulses, during which the MRI signal is in a steady state. Steady state refers to a state where the number of spins aligned with the external magnetic field (longitudinal spins) after pulse N is equal to the number of longitudinal spins after pulse N+1. In this way, the MRI signal is stable over time. The present disclosure relates to estimation of the relaxation time (T1) from gradient echo magnetic resonance images for which the series of RF pulses is interrupted by regularly spaced gaps and consequently, the steady state is disrupted. In an embodiment, the gradient echo magnetic resonance images are acquired by applying ultrafast spoiled gradient echo sequences. The ultrafast gradient echo sequences consist of pluralities of regularly spaced RF pulse sequences with a pre-defined gap between each plurality of RF pulses and in which gradient fields are utilized to manipulate the transverse magnetisation. In another embodiment, the gradient echo magnetic resonance images are acquired by applying interleaved spoiled gradient echo sequences.

In dynamic contrast enhanced (DCE) MRI, a patient is injected with a contrast agent. By continuously obtaining MRI data from the patient, the change in MRI signal induced by the spread of the contrast agent is measured. Underlying pharmacokinetic tissue properties are identifying by relating the change in signal intensity to a change in contrast concentration, which is used for pharmacokinetic modelling. Typically, contrast agents effect both T1 and T2* properties of tissue, although often only the T1 effect is considered. By measuring the change in signal intensity, the contrast concentration is calculated if the relation between signal and T1 and/or T2* is known. The present disclosure can be used for estimation of the contrast concentration curve from gradient echo magnetic resonance images for which the series of RF pulses is interrupted by regularly spaced gaps and consequently, the steady state as defined above is also disrupted. In an embodiment, the gradient echo magnetic resonance images are acquired by applying ultrafast gradient echo sequences. The ultrafast gradient echo sequences consist of pluralities of regularly spaced RF pulse sequences with a pre-defined gap between each plurality of RF pulses and in which gradient fields are utilized to manipulate the transverse magnetisation. In another embodiment, the gradient echo magnetic resonance images are acquired by applying interleaved spoiled gradient echo sequences.

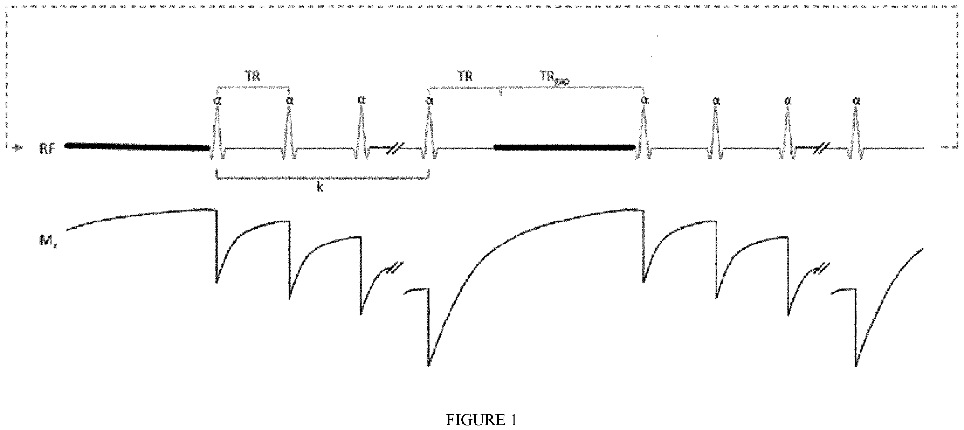

**Figure 1** illustrates a conventional gradient echo sequence. As shown, a plurality of RF pulses ($k$) are applied with the pre-defined gap between each other. The plurality of RF pulses ($k$) are applied for acquisition of an MRI signal. The plurality of RF pulses ($k$) are associated with a repetition time ($TR$). The repetition time is an amount of time between successive RF pulses in the plurality of RF pulses and is constant for an acquisition. A gap that is used to apply the preparation pulses after the plurality of RF pulses (k) is termed as temporal gap in the present disclosure. The temporal gap is indicated by bold line in Figure 1. The temporal gap is used for application of the preparation pulses such as, but not limited to, fat suppression pulses, saturation pulses, and the like. In an embodiment, the temporal gap may be introduced to limit energy deposition. In another embodiment, the temporal gap may be used as contrast mechanism. A person skilled in the art will appreciate that the temporal gap may be used for applications other than the above-mentioned applications, and this should not be considered as limiting. Figure 1 further illustrates longitudinal magnetisation of the protons. Further, an additional relaxation may be introduced after the plurality of RF pulses ($k$), due to the temporal gap which is indicated as a repetition time of the temporal gap ($TR_{gap}$). The longitudinal magnetisation during the repetition time of the temporal gap ($TR_{gap}$) indicates the additional relaxation due to the temporal gap. The present disclosure provides methods and systems to generate an equation representing a relationship between the relaxation time (T1) and an MRI signal, by accounting for the additional relaxation due to the temporal gap.

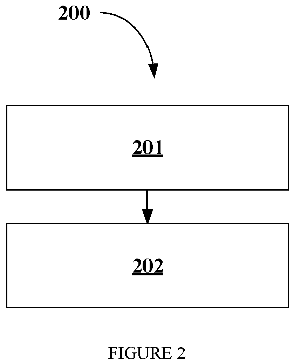

**Figure 2** shows an exemplary flow chart illustrating method steps for estimating the relaxation time (T1) from the gradient echo magnetic resonance images, in accordance with some embodiments of the present disclosure. As illustrated in Figure 2, the method 200 may comprise one or more steps. The method 200 may be described in the general context of computer executable instructions. Generally, computer executable instructions can include routines, programs, objects, components, data structures, procedures, modules, and functions, which perform particular functions or implement particular abstract data types.

The order in which the method 200 is described is not intended to be construed as a limitation, and any number of the described method blocks can be combined in any order to implement the method. Additionally, individual blocks may be deleted from the methods without departing from the scope of the subject matter described herein. Furthermore, the method can be implemented in any suitable hardware, software, firmware, or combination thereof.

At step 201, an equation representing a relationship between a relaxation time (T1) and the MRI signal (S) is generated. The generation of the equation is explained in detail hereafter in the present description. In a conventional steady state gradient echo sequence, signal equation is given by:

$$S = M_0 \sin(\alpha) \frac{1 - e^{-TR/T1}}{1 - e^{-TR/T1} \cos(\alpha)} \quad \dots\dots\dots\dots\dots\dots\dots\dots\dots\dots\dots\dots\dots\dots\dots \quad (1)$$

where S is the MRI signal, $M_0$ is magnetization at steady state, T1 is the relaxation time, TR the repetition time, and $\alpha$ is a flip angle associated with the plurality of RF pulses ($k$). The flip angle ($\alpha$) is an MRI phenomenon by which axis of the proton shifts from longitudinal plane to transverse plane by excitation due to the plurality of RF pulses ($k$). The signal equation (1) enables estimation of the relaxation time (T1) by acquiring images at different flip angles or repetition times. The steady state gradient echo sequence is interrupted by the temporal gap. In the present disclosure, the plurality of RF pulses ($k$) are also termed as a shot of RF pulses. The plurality of RF pulses ($k$) and the temporal gap are termed as a block. Every block includes the repetition time of the temporal gap ($TR_{gap}$) after every 'k' RF pulses per shot.

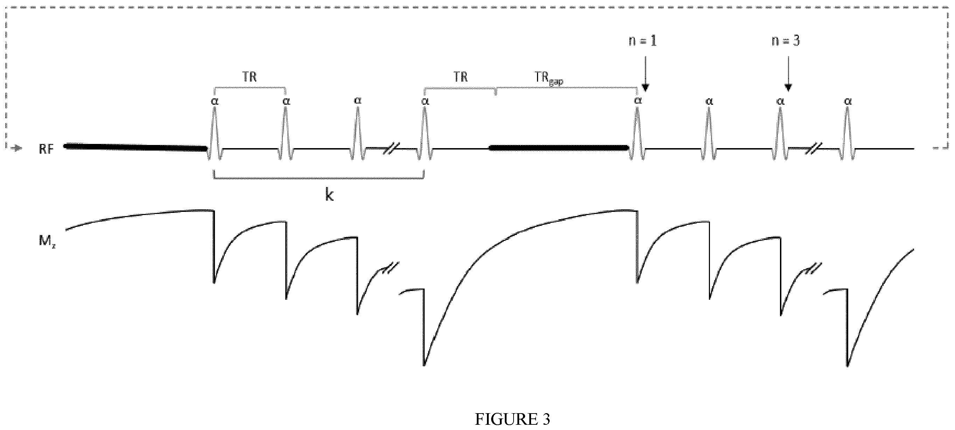

There may be multiple readout techniques to acquire the MRI signal (S) after the temporal gap. In an embodiment, the readout technique may include centric k-space filling in which acquisition of central k-line may start directly after the temporal gap. In another embodiment, the readout technique may include linear k-space filling in which acquisition starts at first top k-line. In another embodiment, k-space filling may be performed arbitrarily, and the central k-space may be acquired 'n' pulses after the temporal gap. Hence, one or more RF pulses may be applied after the temporal gap but before the acquisition of the central k-line is based on the readout technique. A number of RF pulses applied after the temporal gap but before the acquisition of the central k-line is denoted as 'n'. Exemplary values of 'n' are indicated in **Figure 3.** For example, n = 1 represents the acquisition after application of a first RF pulse after the temporal gap. In another example, n = 3 represents the acquisition after application of three RF pulses, after the temporal gap. A person skilled in the art will appreciate that the readout techniques can include techniques other than the above-mentioned techniques.

To correct for the interruption of the steady state due to the temporal gap, it may be assumed that longitudinal magnetization at the end of the temporal gap ($M_{endGap}$) is equal to the magnetization at start of the temporal gap ($M_{startGap}$) with additional T1-relaxation. Further, a new form of steady state may be reached during which the magnetisation repeats itself each block instead of after each RF pulse. The magnetisation is derived from setting magnetisation at a point within a block equal to magnetisation at same point within next block. T1-relaxation may be denoted as additional magnetization at start of the temporal gap and a relaxation factor ($E_{1gap}$). The relaxation factor ($E_{1,gap}$) is indicative of the relaxation time (T1) and the repetition time of the temporal gap ($TR_{gap}$) due to the temporal gap. The relaxation factor ($E_{1,gap}$) is represented in equation (2):

$$E_{1,gap} = e^{-\frac{TR_{gap}}{T1}} \quad \dots\dots\dots\dots\dots\dots\dots\dots\dots\dots\dots\dots\dots\dots\dots\dots \quad (2)$$

The repetition time ($TR$) of the temporal gap is defined as total time for one shot (T) minus the number of lines per shot ($k$) times the repetition time ($TR$) as represented in equation (3):

$$TR_{gap} = T - (k * TR) \quad \dots\dots\dots\dots\dots\dots\dots\dots\dots\dots\dots\dots\dots\dots \quad (3)$$

This results in equation (4) represented below as:

$$M_{endGap} = M_{startGap} + \left(M_0 - M_{startGap}\right)\left(1 - E_{1,gap}\right) = M_{startGap}E_{1,gap} + M_0\left(1 - E_{1,gap}\right)\dots (4)$$

In general, when an RF pulse is applied and TR is waited, a new magnetization along longitudinal axis ($M_{l+1}$) is represented as a recursive formula as function from the magnetization after previous RF pulse ($M_l$) in equation (5):

$$M_{l+1} = M_l \cos(\alpha) + (M_0 - M_l \cos(\alpha))(1 - E_1)\dots\dots\dots (5)$$

where $E_1 = e^{-\frac{TR}{T1}}$.

Considering $M_{endGap}$ as initial point for longitudinal magnetization after $k$ pulses and TRs, the recursive formula results in:

$$M_{startGap} = M_{endGap}\left(E_1 \cos(\alpha)\right)^k + M_0(1 - E_1)\,\frac{1-(E_1\cos(\alpha))^k}{1-E_1\cos(\alpha)}\dots\dots (6)$$

Building upon the new form of steady state, in which $M_{endGap}$ is equal to $M_{endGap}$ from the next block, and adding equation (4) into equation (6), results in equation (7):

$$M_{startGap} = \left(M_{startGap}E_{1,gap} + M_0\left(1 - E_{1,gap}\right)\right)\left(E_1 \cos(\alpha)\right)^k + M_0(1 - E_1)\,\frac{1-(E_1\cos(\alpha))^k}{1-E1\cos(\alpha)}\dots (7)$$

Solving for $M_{startGap}$ and combining with equation (4) results in equation (8):

$$M_{endGap} = M_0\left[\left[\frac{\left(1-E_{1,gap}\right)\left(E_1 \cos(\alpha)\right)^k + (1-E_1)\,\frac{1-(E_1\cos(\alpha))^k}{1-E_1\cos(\alpha)}}{\left(1-E_{1,gap}(E_1 \cos(\alpha))^k\right)}\right]E_{1,gap} + \left(1 - E_{1,gap}\right)\right]\dots\dots (8)$$

The MRI signal (transversal magnetization, $S$) right after the temporal gap thus equals:

$$S = M_{endGap}\sin(\alpha)\dots\dots\dots (9)$$

The MRI signal ($S$) is acquired at an instance after the application of an RF pulse from the plurality of RF pulses ($k$) applied after the temporal gap and prior to the acquisition of the MRI signal ($S$). The MRI signal is acquired '$n$' number of RF pulses after the temporal gap. The MRI signal ($S$) acquired at the instance after '$n$' TR's is represented as:

$$S_n = M_{n-1}\sin(\alpha)\dots\dots\dots (10)$$

Including the effect of '$n$' RF pulses results in the equation representing the relationship between the relaxation time (T1) and the MRI signal ($S$) as:

$$S = \left[\left[\left[\frac{(1-E_{1,gap})\,(E_1\,\cos(\alpha))^k + (1-E_1)\,\frac{1-(E_1\,\cos(\alpha))^k}{1-E_1\,\cos(\alpha)}}{(1-E_{1,gap}(E_1\,\cos(\alpha))^k)}\right]E_{1,gap} + (1-E_{1,gap})\right](E_1\,\cos(\alpha))^{n-1} + \right.$$

$$\left.(1-E_1)\,\frac{1-(E_1\,\cos(\alpha))^{n-1}}{1-E_1\,\cos(\alpha)}\right]\sin(\alpha)\,M_0 \quad\ldots\ldots\ldots\ldots\ldots\ldots\ldots\ldots\ldots\ldots\ldots\ldots\ldots\ldots\ldots (11)$$

Referring back to Figure 2, at step 202, the relaxation time (T1) is estimated from one or more gradient echo magnetic resonance images, based on the equation. In an embodiment, one or more gradient echo sequences may be applied to acquire one or more gradient echo magnetic resonance images. In an embodiment, parameters such as the flip angle ($\alpha$), the repetition time ($TR$) of the plurality of RF pulses ($k$), the repetition time of the temporal gap ($TR_{gap}$), the number of RF pulses in the plurality of RF pulses ($k$), the number of RF pulses before acquisition of the MRI signal ($S$), and the like may be varied based on the readout technique, to estimate the relaxation time (T1) from measured signals at different settings. The equation may be used to determine the MRI signal ($S$) and estimate the relaxation time (T1) in an image for a given k-space read-out pattern. The relaxation time (T1) may also be estimated from an image directly when $M_0$ is known. In a plurality of images, such as in DCE, the changes in the relaxation time (T1) over time may be estimated. The equation may be used where the MRI signal (S) from the MR images is defined from the point at which central k-line is obtained. The equation can also be used in other reconstruction approaches to determine signal per k-line, such as model-based reconstructions.

In an embodiment, effects of T2*-decay may be considered in the estimation of contrast concentrations. Contrast concentrations often affect both the relaxation time (T1) and T2* and hence taking both effects into account results in a more accurate estimate of the contrast concentration, which is required for pharmacokinetic modelling of DCE. MRI decreases T2* relaxation times as well as T1 relaxation times. T2* decay refers to an exponential decrease in transversal magnetisation following initial excitation pulse as a function of time constant T2*. The equation considering the effects of T2*-decay may be represented as

$$S = \left[\left[\left[\frac{\left(1-E_{1,gap}\right)\left(E_1\,cos(\alpha)\right)^k + (1-E_1)\frac{1-\left(E_1\,cos(\alpha)\right)^k}{1-E_1\,cos(\alpha)}}{\left(1-E_{1,gap}\left(E_1\,cos(\alpha)\right)^k\right)}\right]E_{1,gap} + \left(1 - \right.\right.\right.$$

$$\left.\left.E_{1,gap}\right)\right]\left(E_1\,cos(\alpha)\right)^{n-1} + (1-E_1)\frac{1-\left(E_1\,cos(\alpha)\right)^{n-1}}{1-E_1\,cos(\alpha)}\right]\sin(\alpha)M_0 E_2 \ldots\ldots\ldots\ldots\ldots\ldots\ldots\ldots (12)$$

where $E_2 = e^{\frac{TE}{T2*}}$ .

In an embodiment, contrast concentrations may be estimated directly using equation 11 by replacing $\frac{1}{T1}$ by $\frac{1}{T10} + r1 \times C$ or equation 12 by replacing $\frac{1}{T1}$ by $\frac{1}{T10} + r1 \times C$ and replacing $\frac{1}{T2*}$ by $\frac{1}{T20*} + r2 \times C$, where C is the contrast concentration, T10 is the T1 prior to contrast agent arrival, r1 is the longitudinal relaxation rate constant of the contrast concentration, T20* is the T2* relaxation prior to contrast agent arrival and r2 is the transverse relaxation rate constant of contrast concentration.

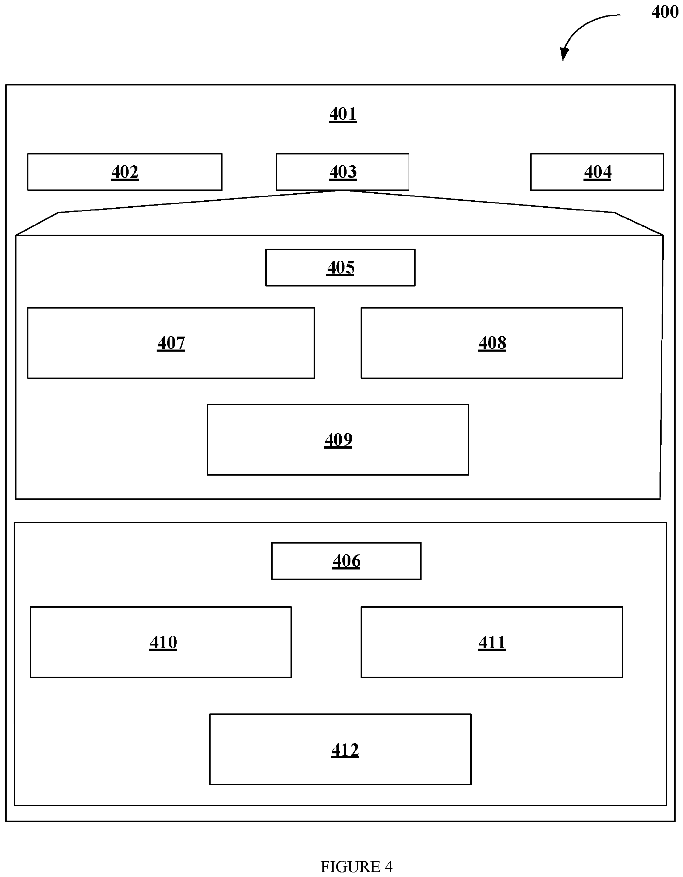

**Figure 4** illustrates a detailed diagram 400 of a computing system 401 for estimating the relaxation time (T1) from the one or more gradient echo magnetic resonance images, in accordance with some embodiments of the present disclosure. The computing system 401 may include Central Processing Units 402 (also referred as "CPUs" or "a processor 402"), Input/ Output (I/O) interface 404, and a memory 403. In an embodiment, the computing system 401 may include a Graphics Processing Unit (GPU). In some embodiments, the memory 403 may be communicatively coupled to the processor 402. The memory 403 stores instructions executable by the processor 402. The processor 402 may comprise at least one data processor for executing program components for executing user or system-generated requests. The memory 403 may be communicatively coupled to the processor 402. The memory 403 stores instructions, executable by the processor 402, which, on execution, may cause the processor 402 to estimate the relaxation time (T1) from the one or more gradient echo magnetic resonance images. In an embodiment, the memory 403 may include one or more modules 406 and data 405. The one or more modules 406 may be configured to perform the steps of the present disclosure using the data 405. In an embodiment, each of the one or more modules 406 may be a hardware unit which may be outside the memory 403 and coupled with the computing system 401. As used herein, the term modules 406 refers to an Application Specific Integrated Circuit (ASIC), an electronic circuit, a Field-Programmable Gate Arrays (FPGA), Programmable System-on-Chip (PSoC), a combinational logic circuit, and/or other suitable components that provide described functionality. The one or more modules 406 when configured with the described functionality defined in the present disclosure will result in a novel hardware. Further, the I/O interface 404 is coupled with the processor 402 through which an input signal or/and an output signal is communicated. In an embodiment, the computing system 401 may be implemented in a variety of systems, such as a laptop computer, a desktop computer, a Personal Computer (PC), a notebook, a smartphone, a tablet, e-book readers, a server, a network server, a cloud-based server, and the like. In an embodiment, the computing system 401 may be associated with an MRI system in which the gradient echo magnetic resonance images are acquired.

In one implementation, the modules 406 may include, for example, an equation generation module 410, an estimation module 411, and other modules 412. It will be appreciated that such aforementioned modules 406 may be represented as a single module or a combination of different modules. In one implementation, the data 405 may include, for example, generation data 407, estimation data 408, and other data 409.

In an embodiment, the equation generation module 410 may be configured to generate the equation representing the relationship between the relaxation time (T1) and the MRI signal (S). The MRI signal (S) is acquired at an instance after application of a RF pulse from the plurality of RF pulses (k) applied after the temporal gap and prior to the acquisition of the MRI signal (S). The equation generation module 410 generates the equation based on the relaxation factor ($E_{1,gap}$) indicative of the relaxation time (T1) and the repetition time of the temporal gap ($TR_{gap}$) due to the temporal gap, and the flip angle ($\alpha$) associated with the plurality of RF pulses (k). Data related to generation of the equation may be stored as the generation data 407 in the memory 403.

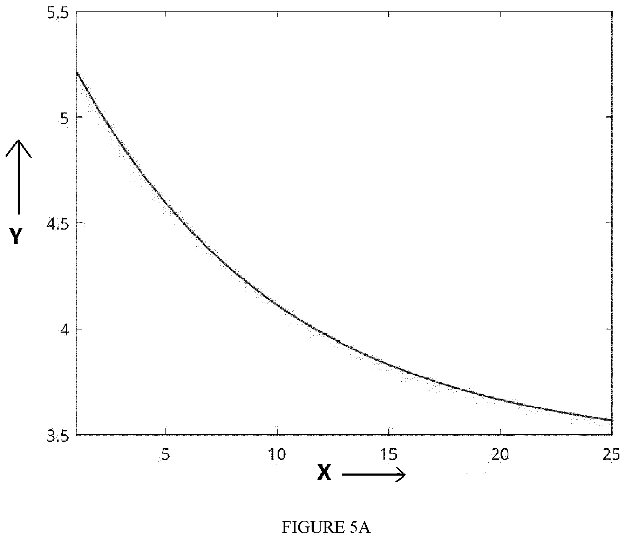

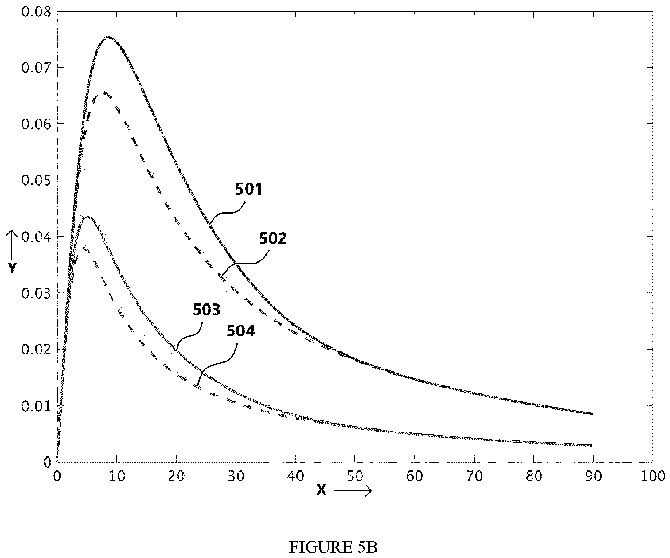

In an embodiment, the estimation module 411 may be configured to estimate the relaxation time (T1) from the one or more gradient echo magnetic resonance images, based on the equation. In an embodiment, parameters such as the flip angle ($\alpha$), the repetition time (TR) of the plurality of RF pulses (k), the repetition time of the temporal gap ($TR_{gap}$), the number of RF pulses in the plurality of RF pulses (k), the number of RF pulses before acquisition of the MRI signal (S), and the like may be varied based on the readout technique, to estimate the relaxation time (T1). Additionally, the equation can be used to estimate T1 from a series of gradient echo images as acquired during contrast injection in DCE MRI. In that case, the parameter $M0$ is estimated from the baseline T1 estimation, which is based on gradient echo images acquired at varying parameters. **Figure 5A** illustrates a graph for estimation of T1 in which X-axis represents the number of RF pulses 'n' after the temporal gap and Y-axis represents measured MRI signal (S). The MRI signal (S) at the centre of k-space, which represents image contrast, is acquired after 'n' RF pulses within the plurality of RF pulses (k). **Figure 5B** illustrates a graph for estimation of T1 in which X-axis represents the flip angle ($\alpha$) and the Y-axis represents the MRI signal (S) for two T1-values 500ms (501, 502) and 1500ms (503, 504). Figure 5B shows difference between the equation with correction for the temporal gap (501, 503) and without correction (502, 504), assuming $M_0$ = 1.

**Table 1** shows sequence parameters for T1-mapping in a phantom which includes vials with known T1 relaxation times. RF-spoiled GRE acquisition at flip angles 2, 5, 10, 15, 20 and 25 degrees may be used for T1-mapping in the phantom. Additionally, data may be acquired at higher flip angles (30, 35, 40 and 45 degrees) in the phantom to verify the equation.

**Table 1**

|  | Spoiled gradient echo | Ultrafast spoiled gradient echo | **Golden-angle Radial Sparse Parallel (GRASP)** |
|---|---|---|---|
| *Sequence type* | Spoiled gradient echo | Spoiled gradient echo, interleaved with temporal gap | Spoiled gradient echo, interleaved, golden angle radial stack-of-stars k-space filling |
| *Field strength* | 3 Tesla (T) | 3 T | 1.5 T |
| *Repetition time (TR) (ms)* | 6.6 (phantom) 7.7 (phantom, high flip angles) | 6.6 (phantom) 7.7 (phantom, high flip angles) | 4.3 |

(continued)

| | Spoiled gradient echo | Ultrafast spoiled gradient echo | Golden-angle Radial Sparse Parallel (GRASP) |
|---|---|---|---|
| Echo time (ms) | 3.2 (phantom) | 3.2 (phantom) | 1.3 |
| | 3.4 (phantom, high flip angles) | 3.4 (phantom, high flip angles) | |
| Flip angle (°) | 2, 5, 10, 15, 20, 25 (,30, 35, 40, 45) | 2, 5, 10, 15, 20, 25 (,30, 35, 40, 45) | 2, 5, 10, 12 (DCE) 15, 20, 25 |
| Field of view (mm) | 223 x 223 x 90 | 223 x 223 x 90 | 380 x 380 x 216 |
| Acquisition matrix (freq. x phase x slices) | 176 x 176 x 18 | 176 x 176 x 18 | 256 x 256 x 72 |
| Lines per shot (k) | NA | 25 | 28 |
| Temporal gap (ms) | NA | 35 | 20 |
| Centre k-line (n) | NA | 1 (Centric) 13 (Linear) | 9 |
| Spoiling phase angle (°) | 117 | 117 | 117 |
| Compressed sensing | None | None | Yes |
| Acquisition time | ~ 2: 45 min (phantom) | ~ 2:50 min (phantom) | ~3 min (T1 map) ~ 12 min (DCE) |
| Additional information | | | 1780 spokes, freebreathing, partial Fourier 5/8 |

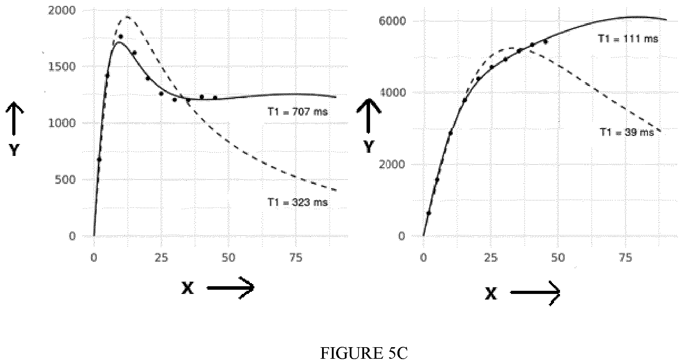

**Figure 5C** shows the difference between T1 estimation based on the equation used for spoiled gradient echo sequence without temporal gap (eq. 1) (dotted line) and T1 estimation based on the equation suggested in the claims (solid line) in two vials of the phantom when images are acquired using a spoiled gradient echo sequence with temporal gap. It can be seen that the estimation based on equation 1 introduces a substantial error in the T1 estimation and the new equation (eq. 11) accurately describes the trend of the acquired signal at different flip angles. This figure contains data acquired at 3 T.

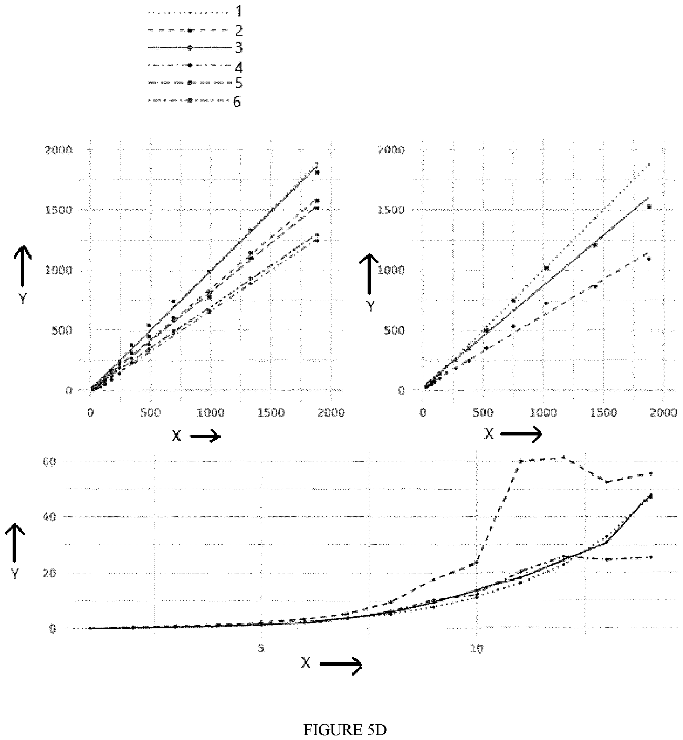

**Figure 5D** visualizes the improvement in accuracy of T1 estimation at 3 T field strength (top left) and 1.5 T (top right). '1' in Figure 5D refers to reference line, '2' represents spoiled gradient echo without temporal gap, '3' refers to spoiled gradient echo with temporal gap (n=1), '4' refers to estimation with default equation with temporal gap (n=1), '5' refers to spoiled gradient echo with temporal gap (n=13), and '6' refers to estimation with default equation with temporal gap (n=13). X-axis in above two graphs in Figure 5D represents reference T1 (ms). Y-axis in the above two graphs in Figure 5D represents measured T1 (ms). X-axis in bottom graph in Figure 5D represents concentration. Y-axis in the bottom graph in Figure 5D represents phantom spheres. It can be appreciated that the T1 estimations where the proposed signal equation was used, are much closer to the reference values. The bottom figure shows the improved accuracy of estimating contrast concentration in DCE modelling, where contrast concentration is computed from the decrease in T1 relaxation time due to the arrival of the contrast agent.

## COMPUTER SYSTEM

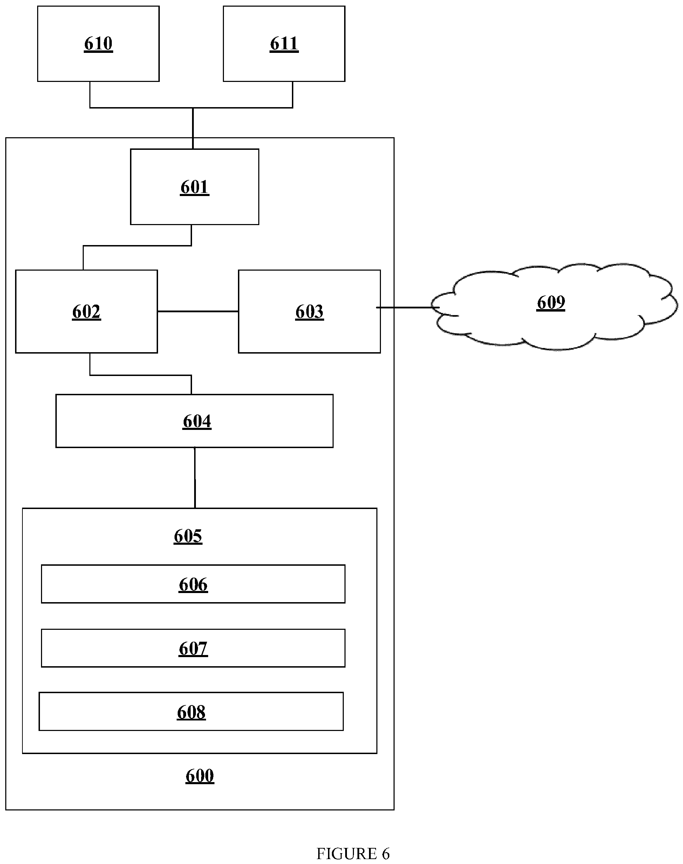

**Figure 6** illustrates a block diagram of an exemplary computer system 600 for implementing embodiments consistent with the present disclosure. In an embodiment, the computer system 600 may be the computing system 401. Thus, the computer system 600 may be used to estimate the relaxation time from the gradient echo magnetic resonance images. The computer system 600 may comprise a Central Processing Unit 602 (also referred as "CPU" or "processor"). The processor 602 may comprise at least one data processor. The processor 602 may include specialized processing units such as integrated system (bus) controllers, memory management control units, floating point units, graphics processing units, digital signal processing units, etc.

The processor 602 may be disposed in communication with one or more input/output (I/O) devices (not shown) via I/O interface 601. The I/O interface 601 may employ communication protocols/methods such as, without limitation, audio, analog, digital, monoaural, RCA, stereo, IEEE (Institute of Electrical and Electronics Engineers) -1394, serial bus, universal serial bus (USB), infrared, PS/2, BNC, coaxial, component, composite, digital visual interface (DVI), high-definition multimedia interface (HDMI), Radio Frequency (RF) antennas, S-Video, VGA, IEEE 802.n /b/g/n/x, Bluetooth, cellular (e.g., code-division multiple access (CDMA), high-speed packet access (HSPA+), global system for mobile communications (GSM), long-term evolution (LTE), WiMax, or the like), etc.

Using the I/O interface 601, the computer system 600 may communicate with one or more I/O devices. For example, the input device 610 may be an antenna, keyboard, mouse, joystick, (infrared) remote control, camera, card reader, fax machine, dongle, biometric reader, microphone, touch screen, touchpad, trackball, stylus, scanner, storage device, transceiver, video device/source, etc. The output device 611 may be a printer, fax machine, video display (e.g., cathode ray tube (CRT), liquid crystal display (LCD), light-emitting diode (LED), plasma, Plasma display panel (PDP), Organic light-emitting diode display (OLED) or the like), audio speaker, etc.

The processor 602 may be disposed in communication with the communication network 609 via a network interface 603. The network interface 603 may communicate with the communication network 609. The network interface 603 may employ connection protocols including, without limitation, direct connect, Ethernet (e.g., twisted pair 10/100/1000 Base T), transmission control protocol/internet protocol (TCP/IP), token ring, IEEE 802.11a/b/g/n/x, etc. The communication network 609 may include, without limitation, a direct interconnection, local area network (LAN), wide area network (WAN), wireless network (e.g., using Wireless Application Protocol), the Internet, etc. The network interface 603 may employ connection protocols include, but not limited to, direct connect, Ethernet (e.g., twisted pair 10/100/1000 Base T), transmission control protocol/internet protocol (TCP/IP), token ring, IEEE 802.11a/b/g/n/x, etc.

The communication network 609 includes, but is not limited to, a direct interconnection, an e-commerce network, a peer to peer (P2P) network, local area network (LAN), wide area network (WAN), wireless network (e.g., using Wireless Application Protocol), the Internet, Wi-Fi, and such. The first network and the second network may either be a dedicated network or a shared network, which represents an association of the different types of networks that use a variety of protocols, for example, Hypertext Transfer Protocol (HTTP), Transmission Control Protocol/Internet Protocol (TCP/IP), Wireless Application Protocol (WAP), etc., to communicate with each other. Further, the first network and the second network may include a variety of network devices, including routers, bridges, servers, computing devices, storage devices, etc.

In some embodiments, the processor 602 may be disposed in communication with a memory 605 (e.g., RAM, ROM, etc. not shown in Figure 6) via a storage interface 604. The storage interface 604 may connect to memory 605 including, without limitation, memory drives, removable disc drives, etc., employing connection protocols such as serial advanced technology attachment (SATA), Integrated Drive Electronics (IDE), IEEE-1394, Universal Serial Bus (USB), fiber channel, Small Computer Systems Interface (SCSI), etc. The memory drives may further include a drum, magnetic disc drive, magneto-optical drive, optical drive, Redundant Array of Independent Discs (RAID), solid-state memory devices, solid-state drives, etc.

The memory 605 may store a collection of program or database components, including, without limitation, user interface 606, an operating system 607, web browser 608 etc. In some embodiments, computer system 600 may store user/application data, such as, the data, variables, records, etc., as described in this disclosure. Such databases may be implemented as fault-tolerant, relational, scalable, secure databases such as Oracle ® or Sybase®.

The operating system 607 may facilitate resource management and operation of the computer system 600. Examples of operating systems include, without limitation, APPLE MACINTOSH$^R$ OS X, UNIX$^R$, UNIX-like system distributions (E.G., BERKELEY SOFTWARE DISTRIBUTION™ (BSD), FREEBSD™, NETBSD™, OPENBSD™, etc.), LINUX DISTRIBUTIONS™ (E.G., RED HAT™, UBUNTU™, KUBUNTU™, etc.), IBM™ OS/2, MICROSOFT™ WINDOWS™ (XP™, VISTA™/7/8, 10 etc.), APPLE$^R$ IOS™, GOOGLE$^R$ ANDROID™, BLACKBERRY$^R$ OS, or the like.

In some embodiments, the computer system 600 may implement the web browser 608 stored program component. The web browser 608 may be a hypertext viewing application, for example MICROSOFT$^R$ INTERNET EXPLORER™, GOOGLE$^R$ CHROME™0, MOZILLA$^R$ FIREFOX™, APPLE$^R$ SAFARI™, etc. Secure web browsing may be provided using Secure Hypertext Transport Protocol (HTTPS), Secure Sockets Layer (SSL), Transport Layer Security (TLS), etc. Web browsers 608 may utilize facilities such as AJAX™, DHTML™, ADOBE$^R$ FLASH™, JAVASCRIPT™, JAVA™, Application Programming Interfaces (APIs), etc. In some embodiments, the computer system 600 may implement a mail server (not shown in Figure) stored program component. The mail server may be an Internet mail server such as Microsoft Exchange, or the like. The mail server may utilize facilities such as ASP™, ACTIVEX™, ANSI™ C++/C#, MICROSOFT$^R$, .NET™, CGI SCRIPTS™, JAVA™, JAVASCRIPT™, PERL™, PHP™, PYTHON™, WEBOBJECTS™, etc. The mail server may utilize communication protocols such as Internet Message Access Protocol (IMAP), Messaging Application Programming Interface (MAPI), MICROSOFT$^R$ exchange, Post Office Protocol (POP), Simple Mail Transfer Protocol (SMTP), or the like. In some embodiments, the computer system 600 may implement a mail client stored program component. The mail client (not shown in Figure) may be a mail viewing application, such as APPLE$^R$ MAIL™, MICROSOFT$^R$ ENTOURAGE™, MICROSOFT$^R$ OUTLOOK™, MOZILLA$^R$ THUNDERBIRD™, etc.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include Random Access Memory (RAM), Read-Only Memory (ROM), volatile memory, non-volatile memory, hard drives, Compact Disc Read-Only Memory (CD ROMs), Digital Video Disc (DVDs), flash drives, disks, and any other known physical storage media.

Embodiments of the present disclosure provides methods and systems to estimate the relaxation time (T1) including effect of interruption of steady state due to the temporal gap. This increases the accuracy in estimation of T1 while maintaining image quality of MRI. The estimated relaxation time (T1) can be used in various applications. Further, the estimated relaxation time (T1) can be further transformed into contrast concentrations in DCE, resulting in more accurate pharmacokinetic modelling and more accurate estimation of tissue perfusion parameters. Furthermore, the effect of contrast concentrations on T2* is considered, resulting in more accurate pharmacokinetic modelling and more accurate estimation of tissue perfusion parameters.

The terms "an embodiment", "embodiment", "embodiments", "the embodiment", "the embodiments", "one or more embodiments", "some embodiments", and "one embodiment" mean "one or more (but not all) embodiments of the invention(s)" unless expressly specified otherwise.

The terms "including", "comprising", "having" and variations thereof mean "including but not limited to", unless expressly specified otherwise.

The enumerated listing of items does not imply that any or all of the items are mutually exclusive, unless expressly specified otherwise. The terms "a", "an" and "the" mean "one or more", unless expressly specified otherwise.

A description of an embodiment with several components in communication with each other does not imply that all such components are required. On the contrary a variety of optional components are described to illustrate the wide variety of possible embodiments of the invention.

When a single device or article is described herein, it will be readily apparent that more than one device/article (whether or not they cooperate) may be used in place of a single device/article. Similarly, where more than one device or article is described herein (whether or not they cooperate), it will be readily apparent that a single device/article may be used in place of the more than one device or article, or a different number of devices/articles may be used instead of the shown number of devices or programs. The functionality and/or the features of a device may be alternatively embodied by one or more other devices which are not explicitly described as having such functionality/features. Thus, other embodiments of the invention need not include the device itself.

The illustrated operations of Figure 2 shows certain events occurring in a certain order. In alternative embodiments, certain operations may be performed in a different order, modified, or removed. Moreover, steps may be added to the above described logic and still conform to the described embodiments. Further, operations described herein may occur sequentially or certain operations may be processed in parallel. Yet further, operations may be performed by a single processing unit or by distributed processing units.

Finally, the language used in the specification has been principally selected for readability and instructional purposes, and it may not have been selected to delineate or circumscribe the inventive subject matter. It is therefore intended that the scope of the invention be limited not by this detailed description, but rather by any claims that issue on an application based here on. Accordingly, the disclosure of the embodiments of the invention is intended to be illustrative, but not limiting, of the scope of the invention, which is set forth in the following claims.

While various aspects and embodiments have been disclosed herein, other aspects and embodiments will be apparent to those skilled in the art. The various aspects and embodiments disclosed herein are for purposes of illustration and are not intended to be limiting, with the true scope being indicated by the following claims.

**Referral Numerals:**

| Referral Number | Description |
|---|---|
| 400 | Detailed diagram |
| 401 | Computing system |
| 402 | Processor |
| 403 | Memory |
| 404 | I/O interface |
| 405 | Data |
| 406 | Modules |

(continued)

| Referral Number | Description |
|---|---|
| 407 | Generation data |
| 408 | Estimation data |
| 409 | Other data |
| 410 | Equation generation module |
| 411 | Estimation module |
| 412 | Other modules |
| 501 | T1 estimation with correction |
| 502 | T1 estimation with correction |
| 503 | T1 estimation without correction |
| 504 | T1 estimation without correction |
| 600 | Computer system |
| 601 | I/O interface |
| 602 | Processor |
| 603 | Network interface |
| 604 | Storage interface |
| 605 | Memory |
| 606 | User interface |
| 607 | Operating system |
| 608 | Web browser |
| 609 | Communication network |
| 610 | Input device |
| 611 | Output device |

**Claims**

1. A method of estimating a relaxation time (T1) from gradient echo magnetic resonance images, the method comprising:

   generating an equation representing a relationship between a relaxation time (T1) and a Magnetic Resonance Imaging (MRI) signal (S) acquired at an instance after application of a Radio Frequency (RF) pulse from a plurality of RF pulses (k) applied after a temporal gap and prior to the acquisition of the MRI signal (S), based on a relaxation factor $E_1$ representing T1 relaxation between two consecutive RF pulses during a repetition time (TR), an additional relaxation factor ($E_{1,gap}$) representing additional T1 relaxation during a repetition time of the temporal gap ($TR_{gap}$), and a flip angle ($\alpha$) of the plurality of RF pulses (k), wherein the temporal gap is used for applying preparation pulses after the plurality of RF pulses (k) having a pre-defined gap between each other; and
   estimating the relaxation time (T1) from one or more gradient echo magnetic resonance images, based on the equation.

2. The method according to claim 1, wherein the MRI signal is acquired 'n' number of RF pulses after the temporal gap.

3. The method according to claim 1 or 2, wherein the flip angle ($\alpha$), the repetition time (TR) of the plurality of RF pulses (k), the repetition time of the temporal gap ($TR_{gap}$), the number of RF pulses in the plurality of RF pulses (k) and/or the number of RF pulses before acquisition of the MRI signal (n) are varied based on a readout technique, to estimate the relaxation time (T1).

4. The method according to claim 1, wherein the equation is generated from a magnetisation, based on an assumption that a steady state is reached for each block comprising the plurality of RF pulses ($k$) and the temporal gap.

5. The method according to claim 4, wherein the magnetisation is derived from setting magnetisation at a point within a block equal to magnetisation at same point within next block.

6. The method according to claim 1 or 2, wherein generation of the equation is further based on effect of T2* decay .

7. The method according to claim 1, 2, or 6, wherein the relaxation time (T1) and/or contrast concentration are estimated from an image, or a plurality of images with no variations in one or more acquisition parameters of the plurality of images.

8. A computing system (401) for estimating a relaxation time (T1) from gradient echo magnetic resonance images, the computing system (401) comprising:

   a processor (402); and
   a memory (403) storing processor-executable instructions, which, on execution, causes the processor (402) to:

   generate an equation representing a relationship between a relaxation time (T1) and a Magnetic Resonance Imaging (MRI) signal ($S$) acquired at an instance after application of a Radio Frequency (RF) pulse from a plurality of RF pulses ($k$) applied after a temporal gap and prior to acquisition of the MRI signal ($S$), based on a relaxation factor $E_1$ representing T1 relaxation between two consecutive RF pulses during a repetition time (TR), an additional relaxation factor ($E_{1,gap}$) representing additional T1 relaxation during a repetition time of the temporal gap ($TR_{gap}$), and a flip angle ($\alpha$) of the plurality of RF pulses ($k$), wherein the temporal gap is used for applying preparation pulses after the plurality of RF pulses ($k$) having a pre-defined gap between each other; and
   estimate the relaxation time (T1) from one or more gradient echo magnetic resonance images, based on the equation.

9. The computing system (401) according to claim 8, wherein the MRI signal ($S$) is acquired *'n'* number of RF pulses after the temporal gap.

10. The computing system (401) according to claim 8 or 9, wherein the flip angle ($\alpha$), the repetition time (*TR*) of the plurality of RF pulses ($k$), the repetition time of the temporal gap ($TR_{gap}$), the number of RF pulses in the plurality of RF pulses ($k$) and/or the number of RF pulses before acquisition of the MRI signal ($n$) are varied based on a readout technique, to estimate the relaxation time (T1).

11. The computing system (401) according to claim 8, wherein the equation is generated from a magnetisation, based on an assumption that a steady state is reached for each block comprising the plurality of RF pulses ($k$) and the temporal gap.

12. The computing system (401) according to claim 11, wherein the magnetisation is derived from setting magnetisation at a point within a block equal to magnetisation at same point within next block.

13. The computing system (401) according to claim 8 or 9, wherein generation of the equation is further based on effect of T2* decay.

14. The computing system (401) according to claim 8, 9, or 13, wherein the relaxation time (T1) and/or contrast concentration are estimated from an image, or a plurality of images with no variations in one or more acquisition parameters of the plurality of images.

FIGURE 1

**200**

```
┌─────────────────────────┐
│                         │
│          201            │
│                         │
└─────────────────────────┘
            │
            ▼
┌─────────────────────────┐
│                         │
│          202            │
│                         │
└─────────────────────────┘
```

FIGURE 2

FIGURE 3

FIGURE 4

FIGURE 5A

FIGURE 5B

FIGURE 5C

FIGURE 5D

| 610 | | 611 |

| 601 |

| 602 | | 603 |

609

| 604 |

605

| 606 |

| 607 |

| 608 |

600

FIGURE 6

Europäisches
Patentamt

European
Patent Office

Office européen
des brevets

# EUROPEAN SEARCH REPORT

**Application Number**

EP 22 16 9337

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GOWLAND P A ET AL: "FAST AND ACCURATE MEASUREMENTS OF T1 USING A MULTI-READOUT SINGLE INVERSION-RECOVERY SEQUENCE", MAGNETIC RESONANCE IN MEDICINE, WILEY-LISS, US, vol. 26, no. 1, 1 July 1992 (1992-07-01), pages 79-88, XP000280564, ISSN: 0740-3194 * the whole document * | 1-14 | INV. G01R33/561 G01R33/44 G01R33/50 G01R33/56 |
| X | HENDERSON E ET AL: "A fast 3D Look-Locker method for volumetric T1 mapping", MAGNETIC RESONANCE IMAGING, ELSEVIER SCIENCE, TARRYTOWN, NY, US, vol. 17, no. 8, 1 October 1999 (1999-10-01), pages 1163-1171, XP002466127, ISSN: 0730-725X, DOI: 10.1016/S0730-725X(99)00025-9 * the whole document * | 1-14 | |
| X | VAN DE MOORTELE P F ET AL: "T1 weighted brain images at 7 Tesla unbiased for Proton Density, T2* contrast and RF coil receive B"1 sensitivity with simultaneous vessel visualization", NEUROIMAGE, ELSEVIER, AMSTERDAM, NL, vol. 46, no. 2, 1 June 2009 (2009-06-01), pages 432-446, XP026467914, ISSN: 1053-8119, DOI: 10.1016/J.NEUROIMAGE.2009.02.009 [retrieved on 2009-02-20] * the whole document * | 1-14 | |

**TECHNICAL FIELDS SEARCHED (IPC)**

G01R

-/--

The present search report has been drawn up for all claims

| Place of search | Date of completion of the search | Examiner |
|---|---|---|
| Munich | 10 October 2022 | Vanhaecke, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt

European Patent Office

Office européen des brevets

**EUROPEAN SEARCH REPORT**

Application Number

EP 22 16 9337

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARQUES J P ET AL: "MP2RAGE, a self bias-field corrected sequence for improved segmentation and T"1-mapping at high field", NEUROIMAGE, ELSEVIER, AMSTERDAM, NL, vol. 49, no. 2, 15 January 2010 (2010-01-15), pages 1271-1281, XP026796256, ISSN: 1053-8119 [retrieved on 2009-10-09] * the whole document * ----- | 1,2,4,5, 8,9,11, 12 | |
| X | US 2018/275235 A1 (REEDER SCOTT B [US] ET AL) 27 September 2018 (2018-09-27) * paragraphs [0044] - [0058], [0065], [0075] - [0107] * * figures 2, 3, 5D * ----- | 1-14 | |

TECHNICAL FIELDS
SEARCHED (IPC)

The present search report has been drawn up for all claims

| Place of search | Date of completion of the search | Examiner |
|---|---|---|
| Munich | 10 October 2022 | Vanhaecke, Nicolas |

EPO FORM 1503 03.82 (P04C01)

## ANNEX TO THE EUROPEAN SEARCH REPORT
## ON EUROPEAN PATENT APPLICATION NO.

EP 22 16 9337

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2022

| Patent document cited in search report | Publication date | Patent family member(s) | Publication date |
|---|---|---|---|
| US 2018275235 A1 | 27-09-2018 | NONE | |

For more details about this annex : see Official Journal of the European Patent Office, No. 12/82